# EUROPEAN PATENT APPLICATION

(11) **EP 2 813 602 A1**
(43) Date of publication of application: **17.12.2014**
(21) Application number: 13171962.7
(22) Date of filing: 14.06.2013
(51) Int. Cl.: C25D 17/06, C25D 17/08

(54) **Holding device for a substrate holder for vertical galvanic metal deposition on a substrate to be treated; and a substrate holder for being inserted in such a device**

(71) Applicant: Atotech Deutschland GmbH, 10553 Berlin (DE)
(72) Inventor: Klingl, Heinz, 86356 Neusäß (DE)
(74) Representative: Wonnemann, Jörg

(57) **Abstract**

The present invention is related to a holding device for a substrate holder for a vertical galvanic metal, preferably copper, deposition on a substrate to be treated comprising at least a first device element, at least a second device element and at least a third device element, wherein the first device element is a first fastening means for fastening the second and third device element; the second device element and the third device element are supporting elements, which are arranged in such a way that there is defined an at least semi-enclosed receiving hole for a substrate holder by the respective spacing between said second device element and said third device element, preferably defined by the respective spacing between first, second and third device element; wherein said second device element further comprise at least a first recess and said third device element further comprise at least a second recess for an accurate positioning and fixation of a substrate holder.

The invention is further related to a substrate holder for being inserted in such a holding device.

## Description

### Field of the Invention

The present invention relates to a holding device for a substrate holder for a vertical galvanic metal, preferably copper, deposition on a substrate to be treated comprising at least a first device element, at least a second device element and at least a third device element. The present invention is further directed to a substrate holder for being inserted in such a device.

### Background of the Invention

It is known in the galvanic industry that a substrate holder carrying a substrate to be treated, such as a wafer, has to be somehow properly and accurately inserted in a vertical galvanic apparatus before a vertical galvanic metal deposition on such a substrate to be treated can be conducted. Further, the substrate holder as well has to be properly and accurately removed out of the vertical galvanic apparatus after finishing the vertical galvanic metal deposition on such a substrate to be treated.

In order to fulfill these requirements for vertical galvanic metal deposition, the industry is generally making use of a transport rack system wherein the respective substrate holder is fixed during the transport from a loading station to the vertical galvanic apparatus by mechanical or magnetic means, which are detachably connecting said substrate holder. After arriving above the vertical galvanic apparatus, the mechanical or magnetic means of the transport rack system releases the detachable connection to the substrate holder whereby the substrate holder is inserted in a holding device for the substrate holder for the subsequent vertical galvanic metal deposition of the substrate to be treated comprised by said substrate holder.

This takeover of the substrate holder from a transport rack system to a holding device for the substrate holder shall be at least semi, ideally fully, automatic.

Attempts to fulfill these requirements of taking over a substrate holder from a transport rack system to a holding device have been partially successful, but have been plagued with problems arising from the kind of fixation on the transport rack system, which are very often based on complex mechanical fixations, which cannot be detachably connected semi, let alone fully, automatic.

Such mechanical holding solutions thus typically increase the cost and complexity of such a takeover process for a substrate holder.

Further, it is often difficult to position and arrange the substrate holder in such a holding device in the required accuracy for the subsequent vertical galvanic metal deposition, in particular semi, preferably fully, automatic.

### Objective of the present Invention

In view of the prior art, it was thus an object of the present invention to provide a holding device for a substrate holder for vertical galvanic, preferably copper, deposition, which shall not exhibit the aforementioned shortcomings of the known prior art devices.

In particular, it was an object of the present invention to provide a holding device which shall be able to position and arrange the substrate holder while at the same time deviations in accuracy of the fixation of the substrate holder should be minimized.

Further, it was an object of the present invention to provide a holding device wherein the takeover of the substrate holder from a transport rack system to the inventive holding device shall be at least semi, ideally fully, automatic connectable.

Furthermore, it was an object to provide a holding device, which enables a substrate holder to be inserted from the top in a straight vertical way in the holding device for a subsequent vertical galvanic metal deposition.

Additionally, it was especially an object of the present invention to provide a substrate holder being suitable to be inserted in such a device.

Further, it was an object to provide an economic device and an economic substrate holder for such a device, which shall both comprise a minimum of required device elements, which shall be at the same time as cheap and as simply constructed as possible.

### Summary of the Invention

These objects and also further objects which are not stated explicitly but are immediately derivable or discernible from the connections discussed herein by way of introduction are achieved by a device having all features of claim 1. Appropriate modifications to the inventive device are protected in dependent claims 2 to 12. Further, claim 13 comprises a substrate holder for being inserted in such a device, whereas appropriate modifications of said inventive substrate holder are comprised by dependent claims 14 and 15.

The present invention accordingly provides a holding device for a substrate holder for a vertical galvanic metal, preferably copper, deposition on a substrate to be treated comprising at least a first device element, at least a second device element and at least a third device element, characterized in that the first device element is a first fastening means for fastening the second and third device element; the second device element and the third device element are supporting elements, which are arranged in such a way that there is defined an at least semi-enclosed receiving hole for a substrate holder by the respective spacing between said second device element and said third device element, preferably defined by the respective spacing between first, second and third device element; wherein said second device element further comprise at least a first recess and said third device element further comprise at least a second recess for an accurate positioning and fixation of a substrate holder.

It is thus possible in an unforeseeable manner to provide a holding device for a substrate holder for vertical galvanic, preferably copper, deposition, which does not exhibit the aforementioned shortcomings of the known prior art devices.

In particular, the present invention provides a holding device which is able to position and arrange the substrate holder while at the same time deviations in accuracy of the fixation of the substrate holder can be minimized.

Further, the present invention provides a holding device wherein the takeover of the substrate holder from a transport rack system to the inventive holding device can be designed at least semi, ideally fully, automatic connectable.

Furthermore, the inventive holding device offers the possibility to insert a substrate holder from the top in a straight vertical way for a subsequent vertical galvanic metal deposition.

Further, the inventive device requires solely a minimum of individual device elements, which are so cheap and simply constructed as it is possible for the purpose of the invention.

### Brief Description of the Figures

For a more complete understanding of the present invention, reference is made to the following Detailed Description of the Invention considered in conjunction with the accompanying figures, in which:
**Fig. 1 a, b and c** show different possible geometric arrangements of the first, second and third device element in accordance with preferred embodiments of the present invention;
**Fig. 2 a, b and c** show other possible geometric arrangements of the first, second and third device element in accordance with, compared to Figures 1a, b and c, alternative preferred embodiments of the present invention;
**Fig. 3 a, b and c** show different possible geometric arrangements of the first, second, third and fourth device element in accordance with preferred embodiments of the present invention;
**Fig. 4 a, b, c and d** show different possible recess geometric structures in accordance with preferred embodiments of the present invention;
**Fig. 5** shows a front view of a holding device of a preferred embodiment of the present invention;
**Fig. 6** **a** shows a perspective front view of the holding device of the preferred embodiment shown in Figure 5, while **Fig. 6 b** shows a side view of the first and second recess of the holding device of the preferred embodiment of Figure 5;
**Fig. 7** **a and b** show two different side views of the holding device of the preferred embodiment of Figure 5;
**Fig. 8** **a** shows a side view of an inventive substrate holder, which is inserted in the holding device of the preferred embodiment of Figure 5, while **Fig. 8 b** shows an explosion view of a part of said side view;
**Fig. 9** **a** shows a side view of the inventive substrate holder of Figure 8, while **Fig. 9 b** shows a perspective front view of said inventive substrate holder inserted in the holding device of the preferred embodiment of Figure 5; and
**Fig. 10** **a** shows an illustrative drawing of an inventive substrate holder comprising in the lower part a first holding means for fixation of a plurality of substrates to be treated, while **Fig. 10 b** shows an illustrative drawing of an inventive substrate holder comprising in the upper part a second holding means for fixation of a plurality of lower parts of a substrate holder in accordance with preferred embodiments of the present invention.

### Detailed Description of the Invention

As used herein, the term "holding device" in accordance with the present invention, refers to a device which is suitable to offer a possibility to insert a substrate holder comprising at least one substrate to be treated in an apparatus for vertical galvanic metal deposition before a vertical galvanic metal deposition method starts; and to remove said substrate holder out of an apparatus for vertical galvanic metal deposition after a vertical galvanic metal deposition method has been finished.

Such a holding device according to the present invention can be an internal part of such an apparatus for vertical galvanic metal deposition or such a holding device can be an additional "external" device, preferably in operative connection with said apparatus for vertical galvanic metal deposition.

As used herein, the term "substrate holder" in accordance with the present invention, refers to any kind of substrate folder, such as wafer holder, suitable to comprise at least one substrate to be treated for a vertical galvanic metal deposition process.

As used herein, the term "galvanic metal", when applied to a vertical galvanic metal deposition on a substrate to be treated in accordance with the present invention, refers to metals which are known to be suitable for such a vertical deposition method. Such galvanic metals comprise gold, nickel, and copper, preferably copper.

As used herein, the term "substrate to be treated", when applied to a vertical galvanic metal deposition on such a substrate in accordance with the present invention, refers to substrates which are round, preferably circular, or angular, preferably polyangular, such as rectangular, quadratic or triangular, or a mixture of round and angular structure elements, such as semicircular.

Such substrates have a diameter ranging from 50 mm to 1000 mm, preferably from 100 mm to 700 mm, and more preferably from 120 mm to 500 mm, in case of a round structure; or a side length ranging from 10 mm to 1000 mm, preferably from 25 mm to 700 mm, and more preferably from 50 mm to 500 mm, in case of an angular, preferably polyangular, structure.

Such substrates can be a printed circuit board, a printed circuit foil, a semiconductor wafer, a solar cell, a photoelectric cell or a monitor cell.

As used herein, the term "receiving hole", when applied to a holding device in accordance with the present invention, refers to a spacing between the second and third device element, preferably between the first, second and third device element, which has to be large enough that a substrate holder can be properly inserted and removed, preferably in a straight vertical way from the top to the bottom and vice versa.

The first and second recess shall ensure that a substrate holder is not solely positioned in the holding device, but also that the connection between said substrate holder and the holding device is a backlash-free connection.

In one embodiment of the present invention, the second and third device elements are supporting elements in form of axial projecting tracks, in particular guide tracks, running parallel to each other thereby forming in conjunction with the first device element an U-shaped geometry of the semi-enclosed receiving hole;
or the second and third device elements are supporting elements in form of axial projecting tracks, in particular guide tracks, running from at least a first fastening point of the first device element and at least from a second fastening point of the first device element forward under decreasing or increasing distances between them, wherein preferably the first and second fastening point of the second and third device element form a common fastening point from which the second and third device elements are both running as projecting legs under increasing distance between them.

It has been found advantageous, if the second and third device element as supporting elements in form of axial projecting tracks are axially movable against each other in order to provide a minimum of flexibility during the insertion and the removal of a substrate holder, in particular for providing an amended increased clamping force for the fixation of the substrate holder.

The first, second and third device element can be each formed in one piece or in several pieces, which are firmly or detachably connected together.

Further, the second and third device element can each comprise nonlinear parts.

In one embodiment, the device further comprise at least a fourth device element connecting the second device element and the third device element thereby defining an fully enclosed receiving hole for a substrate holder by the respective spacing between said second, third and fourth device element, preferably defined by the respective spacing between first, second, third and fourth device element; and/or wherein said fourth device element is detachably connected with the second and third device element by at least a rigid and/or a flexible first connecting element, preferably by a flexible first connecting element such as a spring element.

In particular, such a flexible first connecting element shall offer the advantage of providing an amended increased clamping force for the fixation of the substrate holder.

In one embodiment, the first device element is in operative connection with at least a drive unit for generating a defined certain movement of the holding device for a substrate holder thereby allows generating a defined certain movement of a received substrate holder itself as well, such as in form of an oscillating movement.

Such a drive unit can be in accordance with the present invention any kind of suitable device unit, which can generate a movement of the holding device itself. If the substrate holder is accurately positioned and fixed in the holding device by the first and second recess of the second and third device element, the movement of the holding device transfers automatically the same movement to the substrate holder. This helps to achieve uniform galvanic metal deposition on the substrate to be treated.

In one embodiment, the at least first recess of the second device element and the at least second recess of the third device element possess the same or different geometric structure, preferably the same geometric structure; and/or wherein a recess in the second and third device element is formed by a deepening in such a device element and/or by two opposite protrusions, wherein in particular a recess is formed at least over a partial part, preferably continuous over the full width, of the respective second and/or third device element.

It can be especially preferred that the two opposite protrusions of a recess are each individually adjustable in order to provide and ensure a maximized contact area between the substrate holder and the holding device in the loaded state. The adjustment of the protrusions can be executed by adjusting means, such as screws.

This offers the advantage that a possible wobbling, vibrating and/or moving of the substrate holder in the holding device during a certain movement of the holding device, such as by a driving unit, or in general during the vertical galvanic metal deposition can be avoided. A further advantage of such an adjustment of the protrusions can be a possible adjustment of a desired distance between the received substrate holder comprising the substrate to be treated and the anode(s) of the vertical galvanic metal deposition apparatus, whereby the incident flow on the surface of the substrate to be treated can be controlled and/or regulated.

In one embodiment, each recess of the second and/or third device element comprise at least a base element, at least a first fastening element and at least a second fastening element for accurate positioning and fixation of a substrate holder, wherein said first and second fastening element are two opposite protrusions and/or two opposite wall areas of a deepening in the second and/or third device element.

In a preferred embodiment, each fastening element of each recess of the second and/or third device element comprise at least a first side directed to the inside of the receiving hole and/or at least a second side directed to the base element of the respective recess, wherein said at least first side and/or said at least second side possess at least partially rising edges or trailing edges having an angle related to the perpendicular.

In another preferred embodiment, the at least first side of at least one fastening element, preferably of all fastening elements of the device, of a recess of the second and/or third device element has at least one trailing edge, preferably one trailing edge, having an angle ranging from 10° to 45°, more preferably from 15° to 30°, and more preferably from 17° to 23°, related to the perpendicular, respectively.

This offers the advantage that the fastening elements can be designed by their first and second sides in such a way that an accurate positioning and fixation of the substrate holder by the inventive holding device can be achieved, in particular by choosing certain suitable angles for their rising and/or trailing edges of the first and second sides, which preferably ensures at the same time a maximized contact area contact, in particular for a possible current transfer to the substrate holder.

In a further embodiment, the at least second side of at least one fastening element, preferably of all fastening elements of the device, of a recess of the second and/or third device element has at least one trailing edge, preferably one trailing edge, having an angle ranging from 10° to 45°, more preferably from 15° to 30°, and more preferably from 17° to 23°, related to the perpendicular, respectively.

In one embodiment, the at least first and/or second side of at least one fastening element, preferably of all fastening elements of the device, of a recess of the second and/or third device element have been treated, preferably polished, in a final manufacturing step in order to avoid possible particle contamination by mechanical abrasion during vertical galvanic metal deposition.

In particular during the insertion and/or removal of the substrate holder in or out of the holding device could it commonly happen that small material particles of the surface are generated by mechanical abrasion.

In one embodiment, the device further comprise at least a first support means, wherein such a first support means comprise at least a first magnetic supporting element and/or at least a first low-pressure supporting element, wherein said first support means works in operative connection with the at least first recess and the at least second recess for an accurate positioning and fixation of a substrate holder.

In one embodiment, the device comprises a current connection between an external and/or internal current source and the substrate holder to be inserted in the receiving hole.

It can be especially preferred that the two opposite protrusions of a recess are each individually adjustable in order to provide and ensure a maximized contact area between the substrate holder and the holding device in the loaded state for providing current from an internal and/or external current source, in particular by a current bar, to the substrate holder. The adjustment of the protrusions can be executed by adjusting means, such as screws.

The holding device can further comprise at least a stiffening member, such as crossbars, for an increased stiffening of the holding device and an improved current supply.

Further, the object of the present invention is also solved by a substrate holder for being inserted in such an inventive holding device comprising at least a lower part, wherein a substrate to be treated is arranged, and at least an upper part characterized in that
the upper part of said substrate holder comprises at least a second fastening means, at least a third fastening means and at least a fourth fastening means, wherein the second fastening means and the fourth fastening means are the same or different, preferably the same; and/or wherein the substrate holder comprises in the lower part at least a first holding means for fixation of at least one substrate to be treated, preferably for fixation of a plurality of substrates to be treated; and/or wherein the substrate holder comprises in the upper part at least a second holding means for fixation of at least two individual lower parts of a substrate holder, preferably for fixation of a plurality of lower parts of a substrate holder.

The connection between such an inventive substrate holder and such an inventive device shall be a backlash-free connection.

In one embodiment, the second fastening means and/or the fourth fastening means comprise at least a third fastening element and at least a fourth fastening element, wherein the third fastening element and the fourth fastening element are arranged on the outer sides of the respective second fastening means and/or fourth fastening means; and/or wherein said at least third fastening element and/or said at least fourth fastening element possess at least partially rising edges or trailing edges, preferably at least one rising edge, having an angle ranging from 45° to 80°, more preferably from 60° to 75°, and more preferably from 67° to 73°, related to the perpendicular.

In a preferred embodiment, the third fastening means comprise at least a fifth fastening element and at least a sixth fastening element, wherein the fifth fastening element and the sixth fastening element are arranged on the outer sides of the respective third fastening means; and/or wherein said at least fifth fastening element and/or said at least sixth fastening element possess at least partially rising edges or trailing edges, preferably at least one rising edge, having an angle ranging from 45° to 80°, more preferably from 60° to 75°, and more preferably from 67° to 73°, related to the perpendicular.

It is especially advantageous, if the rising and/or trailing edges of the fastening elements of the substrate holder comprise the complementary angles related to the rising and/or trailing edges of the opposite positioned fastening elements of the respective holding device for ensuring a best possible accurate positioning and fixation of the substrate holder in the holding device.

The present invention thus addresses the problem of improving a holding device for ensuring a best possible accurate positioning and fixation of a substrate holder, which is supposed to be received by such a holding device for a vertical galvanic metal, preferably copper, deposition on a substrate to be treated.

The following non-limiting examples are provided to illustrate an embodiment of the present invention and to facilitate understanding of the invention, but are not intended to limit the scope of the invention, which is defined by the claims appended hereto.

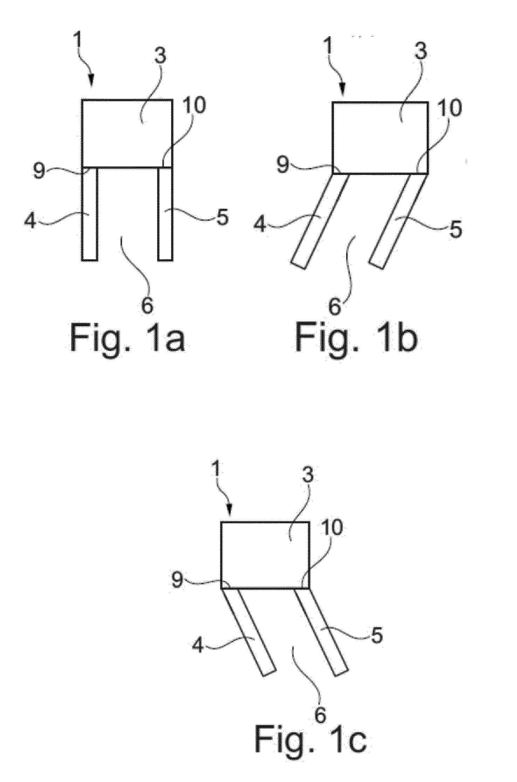

Turning now to the Figures, Figure 1 shows different possible geometric arrangements of the first, second and third device element 3, 4, 5 in accordance with preferred embodiments of the present invention.

Herein, Figure 1 a shows a general geometric arrangement of the first, second and third device element 3, 4, 5 of the holding device 1, wherein the second and third device elements 4, 5 are supporting elements in form of axial projecting tracks running parallel to each other from a first fastening point 9 of the first device element 3 and from a second fastening point 10 of the first device element 3, thereby forming in conjunction with the first device element 3 an U-shaped geometry of the semi-enclosed receiving hole 6. It is noteworthy in this context that in this arrangement the second and the third device element 4, 5 exhibits an angle of 90° related to the first device element 3 of the holding device 1.

In contrast thereto, Figures 1b and c show a general geometric arrangement of the first, second and third device element 3, 4, 5 of the holding device 1, wherein the second and third device elements 4, 5 are supporting elements in form of axial projecting tracks running parallel to each other from a first fastening point 9 of the first device element 3 and from a second fastening point 10 of the first device element 3, thereby forming in conjunction with the first device element 3 an U-shaped geometry of the semi-enclosed receiving hole 6. But, herein the second and the third device element 4, 5 exhibits an angle unequal to 90° related to the first device element 3 of the holding device 1. In all different embodiments shown in Figure 1, the distance between the second and third device element 4, 5 stays constant due to the angle of 90° related to the first device element 3 of the holding device 1.

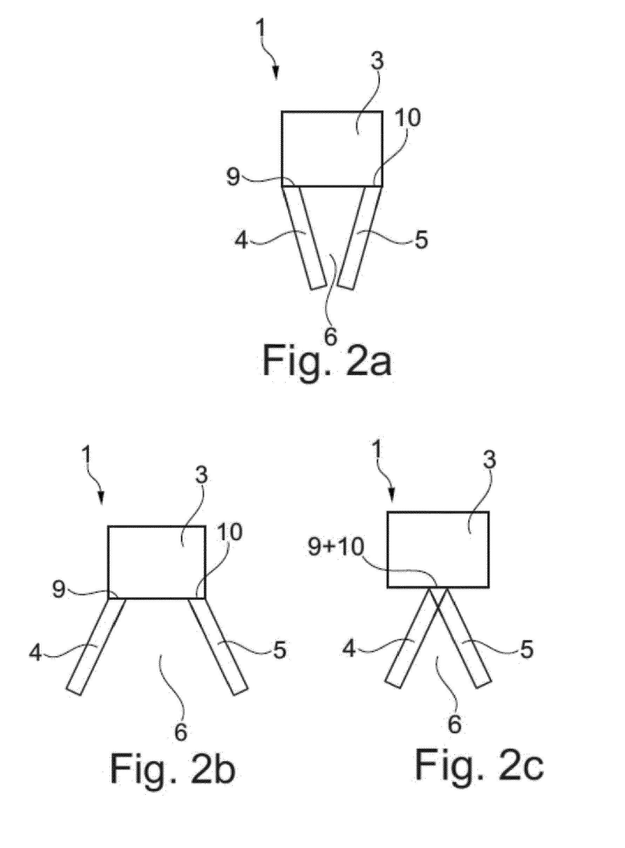

Figure 2 shows other possible geometric arrangements of the first, second and third device element 3, 4, 5 in accordance with, compared to Figures 1 a, b and c, alternative preferred embodiments of the present invention.

Herein, Figure 2 a shows a general geometric arrangement of the first, second and third device element 3, 4, 5 of the holding device 1, wherein the second and third device elements 4, 5 are supporting elements in form of axial projecting tracks, which are running from a first fastening point 9 of the first device element 3 and from a second fastening point 10 of the first device element 3 forward under decreasing distance between them, thereby forming in conjunction with the first device element 3 an semi-enclosed receiving hole 6.

In contrast thereto, Figures 2b and c show a general geometric arrangement of the first, second and third device element 3, 4, 5 of the holding device 1, wherein the second and third device elements 4, 5 are supporting elements in form of axial projecting tracks, which are running from a first fastening point 9 of the first device element 3 and from a second fastening point 10 of the first device element 3 forward under increasing distances between them, thereby forming in conjunction with the first device element 3 an semi-enclosed receiving hole 6.

Herein, Figure 2c shows a general geometric arrangement of the first, second and third device element 3, 4, 5 of the holding device 1, wherein the second and third device elements 4, 5 are supporting elements in form of axial projecting tracks, which are running from a first fastening point 9 of the first device element 3 and from a second fastening point 10 of the first device element 3 forward under increasing distances between them, wherein the first and second fastening point 9, 10 of the second and third device element 4, 5 form a common fastening point from which the second and third device elements 4, 5 are both running as projecting legs under increasing distance between them.

It is noteworthy in this context that in all arrangements shown in Figure 2 the second and the third device elements 4, 5 exhibit an angle unequal to 90° related to the first device element 3 of the holding device 1, while the distance between the second and the third device elements 4, 5 are not staying constant.

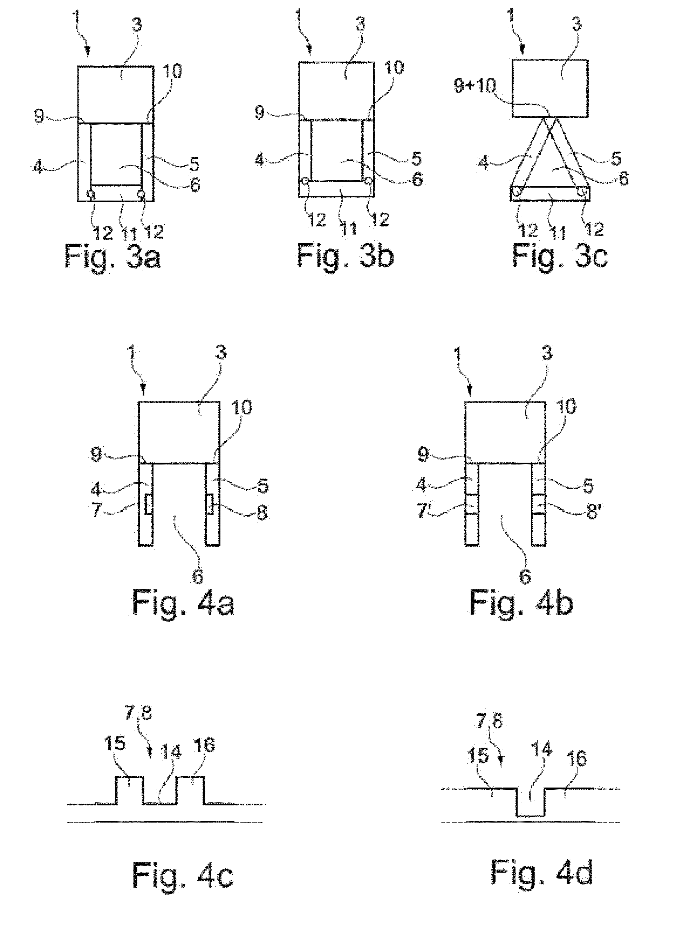

Figure 3 shows different geometric arrangements of the first, second, third and fourth device element 3, 4, 5, 11 in accordance with preferred embodiments of the present invention.

Figures 3 a and b show a holding device 1 comprising a fourth device element 11 connecting the second device element 4 and the third device element 5, thereby defining an fully enclosed receiving hole 6 for a substrate holder 2 by the respective spacing between said first, second, third and fourth device element 3, 4, 5, 11, wherein said fourth device element 11 is detachably connected with the second and third device element 4, 5 by two first connecting elements 12. In these embodiments, the second and third device elements 4, 5 are supporting elements in form of axial projecting tracks running parallel to each other from a first fastening point 9 of the first device element 3 and from a second fastening point 10 of the first device element 3.

In contrast thereto, Figure 3c shows a general geometric arrangement of the first, second, third and fourth device elements 3, 4, 5, 11 of the holding device 1, thereby defining an fully enclosed receiving hole 6 for a substrate holder 2 by the respective spacing between said first, second, third and fourth device element 3, 4, 5, 11, wherein said fourth device element 11 is detachably connected with the second and third device element 4, 5 by two first connecting elements 12. In this embodiment, the second and third device elements 4, 5 are supporting elements in form of axial projecting tracks, which are running from a first fastening point 9 of the first device element 3 and from a second fastening point 10 of the first device element 3 forward under increasing distances between them, wherein the first and second fastening point 9, 10 of the second and third device element 4, 5 form a common fastening point from which the second and third device elements 4, 5 are both running as projecting legs under increasing distance between them.

Figure 4 shows different possible recess geometric structures in accordance with preferred embodiments of the present invention.

Herein, Figures 4 a and b show general geometric arrangements of the first, second and third device element 3, 4, 5 of the holding device 1, wherein the second and third device elements 4, 5 are supporting elements in form of axial projecting tracks running parallel to each other from a first fastening point 9 of the first device element 3 and from a second fastening point 10 of the first device element 3, thereby forming in conjunction with the first device element 3 an U-shaped geometry of the semi-enclosed receiving hole 6. The second and the third device element 4, 5 exhibits an angle of 90° related to the first device element 3 of the holding device 1.

Figure 4 a further comprises a first recess 7 of the second device element 4 and a second recess 8 of the third device element 5 having the same geometric structure, wherein each recess 7, 8 in the second and third device element 4, 5 is formed over a partial part of the respective second and third device element 4, 5. In contrast thereto comprises Figure 4b a first recess 7' of the second device element 4 and a second recess 8' of the third device element 5 having the same geometric structure, wherein each recess 7', 8' in the second and third device element 4, 5 is formed continuous over the full width of the respective second and third device element 4, 5.

Figures 4c and c show general geometric arrangements of a recess 7, 8 in the second and third device element 4, 5, which can be formed by two opposite protrusions (Figure 4 c) or by a deepening in such a device element 4, 5 (Figure 4 d).

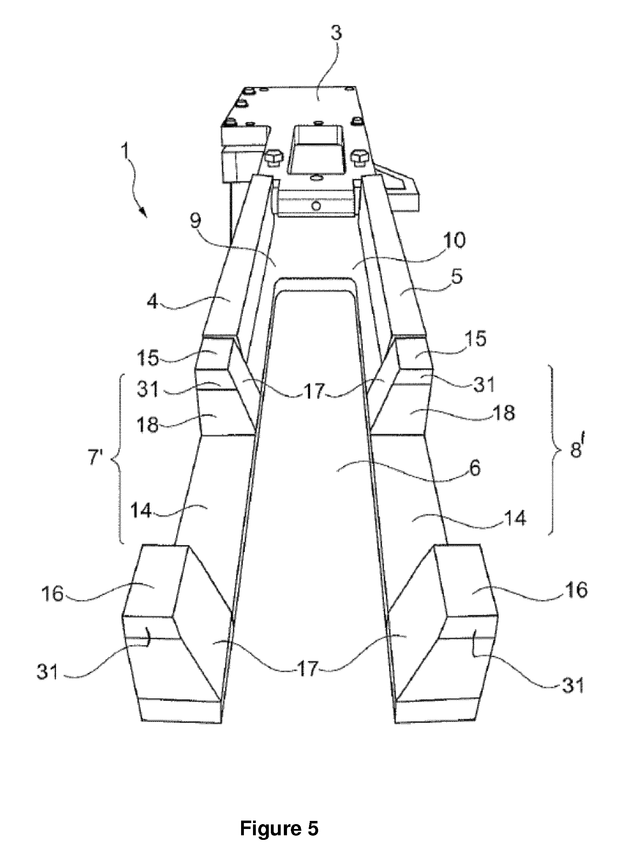

Figure 5 shows a front view of a holding device of a preferred embodiment of the present invention comprising a first, second and third device element 3, 4, 5 of the holding device 1, wherein the second and third device elements 4, 5 are supporting elements in form of axial projecting tracks running parallel to each other from a first fastening point 9 of the first device element 3 and from a second fastening point 10 of the first device element 3, thereby forming in conjunction with the first device element 3 an U-shaped geometry of the semi-enclosed receiving hole 6. The second and the third device element 4, 5 exhibits an angle of 90° related to the first device element 3 of the holding device 1.

The holding device 1 shown in Figure 5 further comprises a first recess 7' of the second device element 4 and a second recess 8' of the third device element 5 having the same geometric structure, wherein each recess 7', 8' in the second and third device element 4, 5 is formed continuous over the full width of the respective second and third device element 4, 5.

Additionally, each recess 7', 8' of the second and third device element 4, 5 comprises a base element 14, a first fastening element 15 and a second fastening element 16 for accurate positioning and fixation of a substrate holder 2, wherein said first and second fastening elements 15, 16 are two opposite protrusions.

Further, each fastening element 15, 16 of each recess 7', 8' of the second and third device element 4, 5 comprises a first side 17 directed to the inside of the receiving hole 6 and a second side 18 directed to the base element 14 of the respective recess 7', 8', wherein said first side 17 exhibits a continuous trailing edge having a constant angle related to the perpendicular and said second side 18 has an upper part having a trailing edge (shaded area in Figure 5) having an angle related to the perpendicular and a straight lower part running along with the perpendicular.

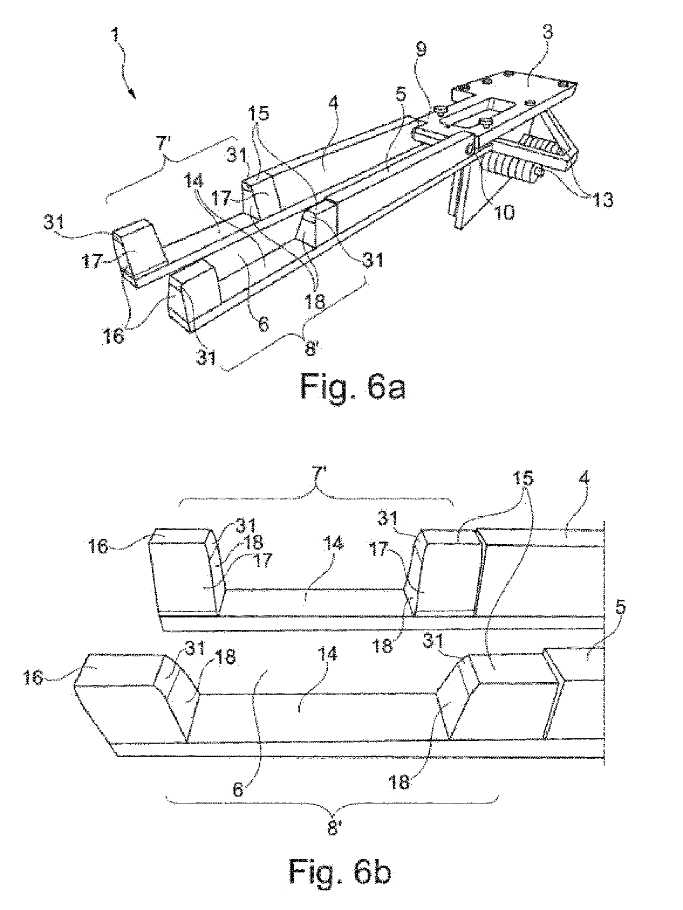

Figure 6 a shows a perspective front view of the holding device 1 of the preferred embodiment shown in Figure 5, while Figure 6b shows a side view of the first and second recess 7', 8' of the holding device 1 of the preferred embodiment shown in Figure 5. Figure 6b comprises additionally a drive unit 13 for generating a defined certain movement of the holding device 1, wherein the first device element 3 is in operative connection with said drive unit 13.

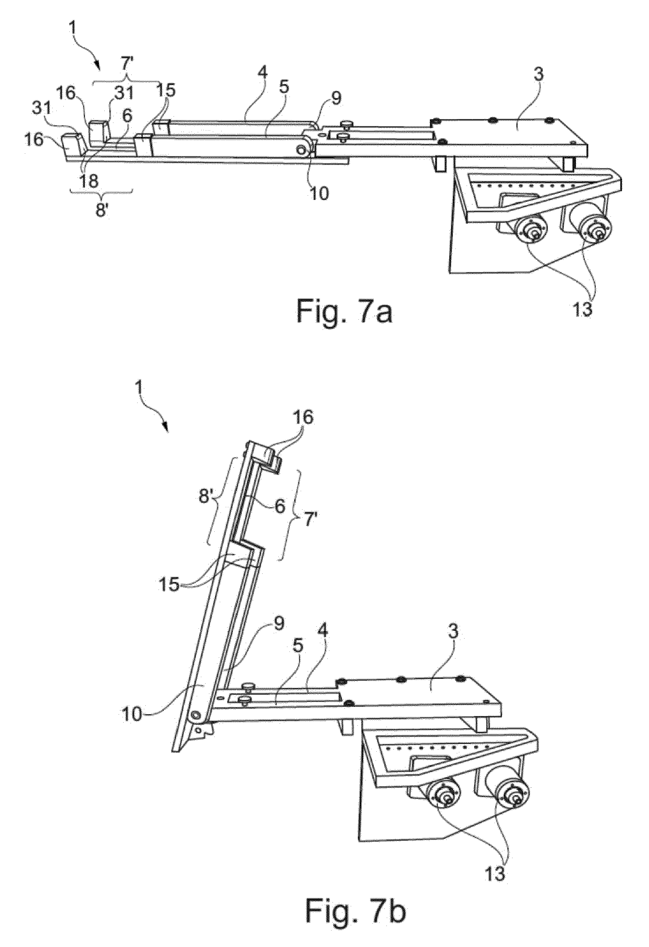

Figures 7 a and b show two different side views of the holding device 1 of the preferred embodiment shown in Figures 5 and 6, wherein the holding device further comprises a folding joint, which offers the advantage for service personal for maintenance and service to achieve an easier access to the apparatus for vertical galvanic metal deposition (Figure 7 b).

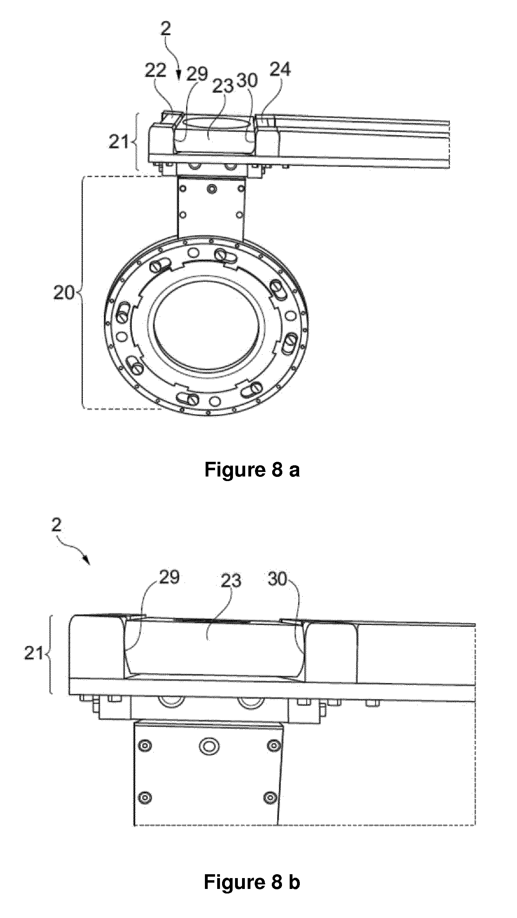

Figure 8 a shows a side view of an inventive substrate holder 2, which is inserted in the holding device 1 of the preferred embodiment shown in Figures 5 to 7, while Figure 8b shows an explosion view of a part of said side view.

Said substrate holder 2 comprises a lower part 20, wherein a substrate to be treated is arranged, and an upper part 21, wherein the upper part 21 comprises a second fastening means 22, a third fastening means 23 and a fourth fastening means 24, wherein the second fastening means 22 and the fourth fastening means 24 are the same.

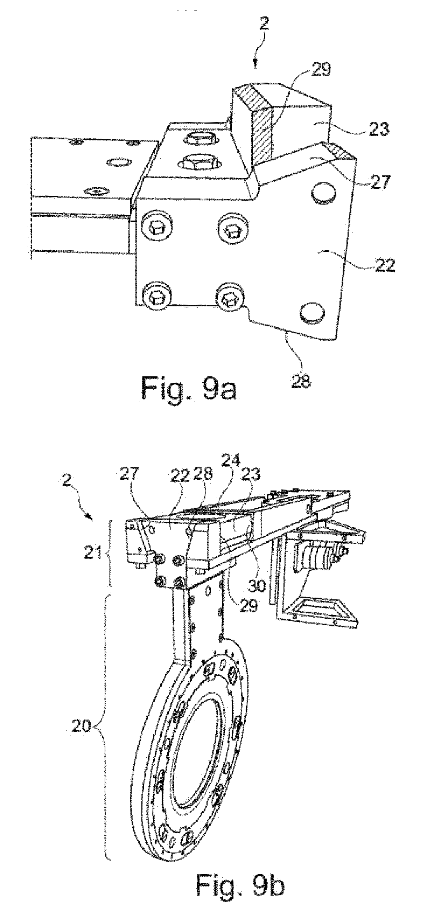

Herein, the third fastening means 23 comprises a fifth fastening element 29 and a sixth fastening element 30, wherein the fifth fastening element 29 and the sixth fastening element 30 are arranged on the outer sides of the respective third fastening means 23. The fifth fastening element 29 and the sixth fastening element 30 possess a straight upper part running along with the perpendicular and a lower part having a rising edge (shaded area in Figure 9 a) having an angle related to the perpendicular. Thus, it is exactly complementary to the fastening elements of the holding device shown in Figures 5 to 7.

Figure 9 a shows a side view of the inventive substrate holder 2 shown in Figure 8, while Figure 9b shows a perspective front view of said inventive substrate holder 2 inserted in the holding device 1 of the preferred embodiment shown in Figures 5 to 7.

Figures 9 a and b show additionally that the second fastening means 22 and the fourth fastening means 24 comprise a third fastening element 27 and a fourth fastening element 28, wherein the third fastening element 27 and the fourth fastening element 28 are arranged on the outer sides of the respective second fastening means 22 and fourth fastening means 24. The third fastening element 27 and the fourth fastening element 28 possess a straight upper part running along with the perpendicular and a lower part having a rising edge (shaded area in Figure 9 a) having an angle related to the perpendicular.

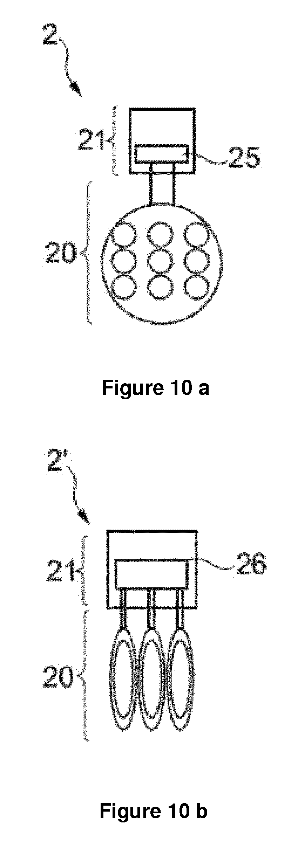

Figure 10 a shows an illustrative drawing of a substrate holder 2 comprising in the lower part 20 a first holding means 25 for fixation of a plurality of substrates to be treated, while Figure 10b shows an illustrative drawing of a substrate holder 2 comprising in the upper part 21 a second holding means 26 for fixation of a plurality of lower parts 20 of a substrate holder 2 in accordance with preferred embodiments of the present invention.

While the principles of the invention have been explained in relation to certain particular embodiments, and are provided for purposes of illustration, it is to be understood that various modifications thereof will become apparent to those skilled in the art upon reading the specification. Therefore, it is to be understood that the invention disclosed herein is intended to cover such modifications as fall within the scope of the appended claims. The scope of the invention is limited only by the scope of the appended claims.

**Reference sians**

| | |
|---|---|
| 1 | Holding device for a substrate holder |
| 2 | Substrate holder |
| 3 | First device element (first fastening means) |
| 4 | Second device element |
| 5 | Third device element |
| 6 | Receiving hole |
| 7, 7' | First recess |
| 8, 8' | Second recess |
| 9 | First fastening point |
| 10 | Second fastening point |
| 11 | Fourth device element |
| 12 | First connecting element |
| 13 | Drive unit |
| 14 | Base element |
| 15 | First fastening element |
| 16 | Second fastening element |
| 17 | First side of a fastening element of a recess |
| 18 | Second side of a fastening element of a recess |
| 20 | Lower part of a substrate holder |
| 21 | Upper part of a substrate holder |
| 22 | Second fastening means |
| 23 | Third fastening means |
| 24 | Fourth fastening means |
| 25 | First holding means |
| 26 | Second holding means |
| 27 | Third fastening element |
| 28 | Fourth fastening element |
| 29 | Fifth fastening element |
| 30 | Sixth fastening element |

## Claims

1. Holding device (1) for a substrate holder (2) for a vertical galvanic metal, preferably copper, deposition on a substrate to be treated comprising at least a first device element (3), at least a second device element (4) and at least a third device element (5) **characterized in that**
the first device element (3) is a first fastening means for fastening the second and third device element (4,5); the second device element (4) and the third device element (5) are supporting elements, which are arranged in such a way that there is defined an at least semi-enclosed receiving hole (6) for a substrate holder (2) by the respective spacing between said second device element (4) and said third device element (5), preferably defined by the respective spacing between first, second and third device element (3,4,5); wherein said second device element (4) further comprise at least a first recess (7) and said third device element (5) further comprise at least a second recess (8) for an accurate positioning and fixation of a substrate holder (2).

2. Device according to claim 1 **characterized in that** the second and third device elements (4,5) are supporting elements in form of axial projecting tracks, in particular guide tracks, running parallel to each other thereby forming in conjunction with the first device element (3) an U-shaped geometry of the semi-enclosed receiving hole (6);
or the second and third device elements (4,5) are supporting elements in form of axial projecting tracks, in particular guide tracks, running from at least a first fastening point (9) of the first device element (3) and at least from a second fastening point (10) of the first device element (3) forward under decreasing or increasing distances between them, wherein preferably the first and second fastening point (9,10) of the second and third device element (4,5) form a common fastening point from which the second and third device elements (4,5) are both running as projecting legs under increasing distance between them.

3. Device according to claim 1 or 2 **characterized in that** the device (1) further comprise at least a fourth device element (11) connecting the second device element (4) and the third device element (5) thereby defining an fully enclosed receiving hole (6) for a substrate holder (6) by the respective spacing between said second, third and fourth device element (4,5,11), preferably defined by the respective spacing between first, second, third and fourth device element (3,4,5,11); and/or wherein said fourth device element (11) is detachably connected with the second and third device element (4,5) by at least a rigid and/or a flexible first connecting element (12), preferably by a flexible first connecting element (12) such as a spring element.

4. Device according to one of the preceding claims **characterized in that** the first device element (3) is in operative connection with at least a drive unit (13) for generating a defined certain movement of the holding device (1) for a substrate holder (2) thereby allows generating a defined certain movement of a received substrate holder (2) itself as well, such as in form of an oscillating movement.

5. Device according to one of the preceding claims **characterized in that** the at least first recess (7) of the second device element (4) and the at least second recess (8) of the third device element (5) possess the same or different geometric structure, preferably the same geometric structure; and/or wherein a recess (7,8) in the second and third device element (4,5) is formed by a deepening in such a device element (4,5) and/or by two opposite protrusions, wherein in particular a recess (7,8) is formed at least over a partial part, preferably continuous over the full width, of the respective second and/or third device element (4,5).

6. Device according to one of the preceding claims **characterized in that** each recess (7,8) of the second (4) and/or third (5) device element comprise at least a base element (14), at least a first fastening element (15) and at least a second fastening element (16) for accurate positioning and fixation of a substrate holder (2), wherein said first and second fastening element (15,16) are two opposite protrusions and/or two opposite wall areas of a deepening in the second (4) and/or third (5) device element.

7. Device according to claim 6 **characterized in that** each fastening element (15,16) of each recess (7,8) of the second (4) and/or third (5) device element comprise at least a first side (17) directed to the inside of the receiving hole (6) and/or at least a second side (18) directed to the base element (14) of the respective recess (7,8), wherein said at least first side (17) and/or said at least second side (18) possess at least partially rising edges or trailing edges having an angle related to the perpendicular.

8. Device according to claim 7 **characterized in that** the at least first side (17) of at least one fastening element (15,16), preferably of all fastening elements (15,16) of the device (1), of a recess (7,8) of the second (4) and/or third (5) device element has at least one trailing edge, preferably one trailing edge, having an angle ranging from 10° to 45°, more preferably from 15° to 30°, and more preferably from 17° to 23°, related to the perpendicular, respectively.

9. Device according to claim 7 **characterized in that** the at least second side (18) of at least one fastening element (15,16), preferably of all fastening elements (15,16) of the device (1), of a recess (7,8) of the second (4) and/or third (5) device element has at least one trailing edge, preferably one trailing edge, having an angle ranging from 10° to 45°, more preferably from 15° to 30°, and more preferably from 17° to 23°, related to the perpendicular, respectively.

10. Device according to one of claims 7 to 9 **characterized in that** the at least first (17) and/or second side (18) of at least one fastening element (15,16), preferably of all fastening elements (15,16) of the device (1), of a recess (7,8) of the second (4) and/or third (5) device element have been treated, preferably polished, in a final manufacturing step in order to avoid possible particle contamination by mechanical abrasion during vertical galvanic metal deposition.

11. Device according to one of the preceding claims **characterized in that** the device (1) further comprise at least a first support means, wherein such a first support means comprise at least a first magnetic supporting element and/or at least a first low-pressure supporting element, wherein said first support means works in operative connection with the at least first recess (7) and the at least second recess (8) for an accurate positioning and fixation of a substrate holder (2).

12. Device according to one of the preceding claims **characterized in that** the device (1) comprises a current connection between an external and/or internal current source and the substrate holder (2) to be inserted in the receiving hole (6).

13. Substrate holder (2) for being inserted in a holding device (1) according to one of claims 1 to 12 comprising at least a lower part (20), wherein a substrate to be treated is arranged, and at least an upper part (21) **characterized in that**
the upper part (21) of said substrate holder (2) comprises at least a second fastening means (22), at least a third fastening means (23) and at least a fourth fastening means (24), wherein the second fastening means (22) and the fourth fastening means (24) are the same or different, preferably the same; and/or wherein the substrate holder (2) comprises in the lower part (20) at least a first holding means (25) for fixation of at least one substrate to be treated, preferably for fixation of a plurality of substrates to be treated; and/or wherein the substrate holder (2) comprises in the upper part (21) at least a second holding means (26) for fixation of at least two individual lower parts (20) of a substrate holder (2), preferably for fixation of a plurality of lower parts (20) of a substrate holder (2).

14. Substrate holder according to claim 13 **characterized in that** the second fastening means (22) and/or the fourth fastening means (24) comprise at least a third fastening element (27) and at least a fourth fastening element (28), wherein the third fastening element (27) and the fourth fastening element (28) are arranged on the outer sides of the respective second fastening means (22) and/or fourth fastening means (24); and/or wherein said at least third fastening element (27) and/or said at least fourth fastening element (28) possess at least partially rising edges or trailing edges, preferably at least one rising edge, having an angle ranging from 45° to 80°, more preferably from 60° to 75°, and more preferably from 67° to 73°, related to the perpendicular.

15. Substrate holder according to claim 13 or 14 **characterized in that** the third fastening means (23) comprise at least a fifth fastening element (29) and at least a sixth fastening element (30), wherein the fifth fastening element (29) and the sixth fastening element (30) are arranged on the outer sides of the respective third fastening means (23); and/or wherein said at least fifth fastening element (29) and/or said at least sixth fastening element (30) possess at least partially rising edges or trailing edges, preferably at least one rising edge, having an angle ranging from 45° to 80°, more preferably from 60° to 75°, and more preferably from 67° to 73°, related to the perpendicular.
